(19) Europäisches Patentamt
European Patent Office
Office européen des brevets

(11) **EP 3 692 679 B1**

(12) **EUROPÄISCHE PATENTSCHRIFT**

(45) Veröffentlichungstag und Bekanntmachung des Hinweises auf die Patenterteilung:
**15.11.2023  Patentblatt 2023/46**

(21) Anmeldenummer: **18773743.2**

(22) Anmeldetag: **19.09.2018**

(51) Internationale Patentklassifikation (IPC):
**H04L 7/08** *(2006.01)*      **H04Q 9/00** *(2006.01)*
**G01D 5/244** *(2006.01)*     **B60R 21/01** *(2006.01)*
**H03K 5/26** *(2006.01)*

(52) Gemeinsame Patentklassifikation (CPC):
**H04L 7/08; G01D 3/08; G01D 21/00; G06F 1/04; G06F 1/12; H03K 5/19; H03K 5/26;** H04L 7/0012

(86) Internationale Anmeldenummer:
**PCT/EP2018/075320**

(87) Internationale Veröffentlichungsnummer:
**WO 2019/068465 (11.04.2019 Gazette 2019/15)**

(54) **VORRICHTUNG UND VERFAHREN ZUR ÜBERWACHUNG EINES SENSORTAKTSIGNALS**

DEVICE AND METHOD FOR MONITORING THE CLOCK OF A SENSOR UNIT

DISPOSITIF ET PROCÉDÉ DE SURVEILLANCE D'HORLOGE D'UN CAPTEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **05.10.2017   DE 102017217719**

(43) Veröffentlichungstag der Anmeldung:
**12.08.2020   Patentblatt 2020/33**

(73) Patentinhaber: **Robert Bosch GmbH**
**70442 Stuttgart (DE)**

(72) Erfinder:
• **HAUG, Michael**
**70499 Stuttgart (DE)**
• **WEISS, Guenter**
**74399 Walheim (DE)**
• **WALZ, Michel**
**72800 Eningen (DE)**
• **BOMMER, Daniela**
**71229 Leonberg (Warmbronn) (DE)**
• **SCHOU, Frank**
**71254 Ditzingen (DE)**
• **GSCHWIND-SCHILLING, Rainer**
**71277 Rutesheim (DE)**
• **ROZIC, Darko**
**72762 Reutlingen (DE)**
• **AJANOVIC, Mustafa**
**71067 Sindelfingen (DE)**
• **CONRADT, Joerg**
**70806 Kornwestheim (DE)**
• **EWERT, Marlon Ramon**
**74199 Untergruppenbach (DE)**
• **HAIST, Kevin**
**71254 Ditzingen (DE)**

(56) Entgegenhaltungen:
**EP-A1- 2 241 952          WO-A1-2013/083560
WO-A2-2009/031060     DE-A1-102012 203 664**

• **Bosch et al.: "Peripheral Sensor Interface Technical Specification V2.1", , 1. Januar 2012 (2012-01-01), Seiten 1-59, XP055197813, Gefunden im Internet: URL:http://psi5.org/fileadmin/user_upload/ 01_psi5.org/04_Specification/Specification s_PDFs/psi5_spec_v2d1_base.pdf [gefunden am 2015-06-23]**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung geht aus von einem Verfahren zur Überwachung eines Sensortaktsignals in einer Sensoreinheit nach der Gattung des unabhängigen Patentanspruchs 1. Gegenstand der vorliegenden Erfindung ist auch eine Vorrichtung zur Durchführung eines solchen Verfahrens.

Peripheral Sensor Interface 5 (PSI5) ist ein offener Standard. Aufbauend auf dem bisherigen PAS4 Protokoll unterstützt der PSI5 Standard Applikationen, in denen bis zu vier Sensoren pro Busknoten in unterschiedlichen Konfigurationen von einem Steuergerät abgefragt werden können. Auch eine bidirektionale Kommunikation zur Sensorkonfigurierung und Diagnose ist vorgesehen.

In Airbag-Systemen werden beispielsweise Daten von Druck- oder Beschleunigungssensoren über strommodulierte Zweidraht-Busse ausgewertet, die über ein Manchester codiertes Protokoll mit dem Steuergerät kommunizieren. Im PSI5 Standard sind auch mögliche Betriebsarten festgelegt. Diese unterscheiden sich zunächst in synchrone und asynchrone Betriebsmodi. Bei den synchronen Betriebsmodi ergeben sich je nach Verschaltung der Sensoren mit der Steuereinheit die drei Betriebsarten: Parallel BUS Mode, in dem die Sensoren parallel geschaltet sind, Universal BUS Mode, in dem die Sensoren seriell verschaltet sind, und Daisy Chain BUS Mode. Kombiniert mit anderen Parametern, wie gesamte Anzahl der Zeitschlitze, Datenrate, Datenwortlänge, Parity-/CRC Überwachung, erlaubt der PSI5 Standard unterschiedliche Realisierungsmöglichkeiten. Weit verbreitet ist die Verwendung einer 10-Bit Datenwortlänge.

Heutige Druck-, Beschleunigungs- und/oder Drehratensensoren umfassen in der Regel eine anwendungsspezifische integrierte Schaltung (ASIC) bzw. einen Mikrocontroller sowie ein Sensorelement. Diese Komponenten sind in einem Modulgehäuse untergebracht. Die Module wiederum werden auf einer Leiterplatte bzw. auf einen Halter gelötet oder kalt kontaktiert. Um die Leiterplatte bzw. das Modul befindet sich ein Kunststoffgehäuse mit Stecker. Über den Stecker erfolgt die Kontaktierung der Sensoreinheit über einen Kabelbaum zum Steuergerät. In der Praxis kann es vorkommen, dass ein Sensortaktoszillator einer Sensoreinheit wegdriftet, bzw. kaputt geht. Dadurch können die Signale der Sensoreinheiten auf dem PSI5 Bus gestört werden.

Aus der WO 2009/031060 A2 sind eine Taktüberwachungseinheit und ein elektronisches System bekannt, das von mindestens einem Taktsignal getaktet wird und die Taktüberwachungseinheit verwendet. Die Taktüberwachungseinheit analysiert das mindestens eine Taktsignal auf der Grundlage eines Überwachungstaktsignals, welche zusammen mit dem mindestens einen Taktsignal oder separat zu der Taktüberwachungseinheit bereitgestellt wird. Die Taktüberwachungseinheit umfasst mindestens eine Aktivitätseinheit, eine Abweichungseinheit und einen Hilfstaktgenerator. Der Hilfstaktgenerator gibt ein Hilfstaktsignal aus. Die Aktivitätseinheit erfasst das Vorhandensein des Überwachungstaktsignals basierend auf dem Hilfstaktsignal und das Vorhandensein des Zusatztaktsignals basierend auf dem Überwachungstaktsignal. Die Abweichungseinheit erkennt Taktfehler im Überwachungstaktsignal basierend auf dem Hilfstaktsignal. Das bedeutet, dass durch das Definieren geeigneter Schwellenwerte die Abweichungseinheit dazu ausgelegt werden kann, Fehlersignale zum Anzeigen einer zu hohen oder viel zu niedrigen Taktfrequenz und/oder ein Warnsignals zum Anzeigen einer zu niedrigen Taktfrequenz auszugeben. Mit der Taktüberwachungseinheit kann das mindestens eine Taktsignal genauer überwacht werden, und es ist möglich, auf unterschiedliche Taktfehler in dem mindestens einen Taktsignal mit unterschiedlichem Maßnahmen zu reagieren.

Aus der DE 10 2012 203 664 A1 ist ein Verfahren zur Nachführung eines Frequenzsignals sowie eine zughörige Sensoreinheit für ein Fahrzeug bekannt. Das Frequenzsignal wird innerhalb einer Sensoreinheit mit einer vorgegebenen Periodendauer erzeugt und bereitgestellt. Über mindestens eine Schnittstelleneinheit wird mindestens ein Referenzsignal empfangen, wobei das bereitgestellte Frequenzsignal von einem ersten Zähler innerhalb der Sensoreinheit gezählt wird.

Hierbei wird ein aktueller Zählerstand des ersten Zählers in Abhängigkeit des mindestens einen Referenzsignals in einem ersten Register innerhalb der Sensoreinheit gespeichert und von einer Vergleichseinheit innerhalb der Einheit mit einem vorgegebenen Wertebereich verglichen, welcher in Abhängigkeit von mindestens einem vorgegebenen Schwellwert definiert wird. Von der Vergleichseinheit wird ein Einstellsignal erzeugt, welches ein Nachführen der Frequenz des Frequenzsignals bewirkt, wenn der vom ersten Register als Ausgabesignal ausgegebene aktuelle Zählerstand des ersten Zählers außerhalb des vorgegebenen Wertebereichs liegt, wobei über das Einstellsignal ein Nachführsignal für das Frequenzsignal erzeugt wird. Hierbei kann ein erstes Einstellsignal erzeugt werden, welches über das Nachführsignal eine Erhöhung der Frequenz des Frequenzsignals bewirkt, wenn die aktuelle Frequenz des bereitgestellten Frequenzsignals zu niedrig ist. Alternativ kann ein zweites Einstellsignal erzeugt werden, welches über das Nachführsignal eine Absenkung der Frequenz des Frequenzsignals bewirkt, wenn die aktuelle Frequenz des bereitgestellten Frequenzsignals zu hoch ist.

Offenbarung der Erfindung

Das Verfahren zur Überwachung eines Sensortaktsignals in einer Sensoreinheit mit den Merkmalen des unabhängigen Patentanspruchs 1 und die Vorrichtung zur Überwachung eines Sensortaktsignals in einer Sensoreinheit mit den Merkmalen des unabhängigen Patentanspruchs 3 haben den Vorteil, dass ein Fehler des Sensoroszillators bereits in der Sensoreinheit erkannt wird, bevor die Signale auf dem PSI5 Bus fehlerhaft sind und eine entsprechende Fehlermeldung aus der Sensoreinheit heraus gesendet wird. Ausführungsformen der vorliegenden Erfindung erkennen ein fehlerhaftes oder wegdriftendes Sensortaktsignal und senden in vorteilhafter Weise innerhalb einer vorgegebenen Zeitspanne eine entsprechende Fehlermeldung an das Steuergerät. Da Oszillatorfehler schnell und zuverlässig erkannt und außerdem auch klar zugeordnet werden können, kann die Diagnoseabdeckung des korrespondierenden Airbag-Systems erhöht werden. Dadurch kann in vorteilhafter Weise die Sicherheit im Straßenverkehr erhöht werden, da Sensoreinheiten mit einem defekten Sensoroszillator schneller zur Ausgabe einer Warnmeldung führen und somit auch schneller ausgetauscht werden können, so dass Fehlnichtauslösungen im Airbag-System in vorteilhafter Weise reduziert werden können.

Ausführungsformen der vorliegenden Erfindung stellen ein Verfahren zur Überwachung eines Sensortaktsignals in einer Sensoreinheit zur Verfügung, welches für eine Datenübertragung zwischen der Sensoreinheit und einem Steuergerät mit einer vorgegebenen Periodendauer erzeugt und ausgegeben wird, wobei ein Referenztaktsignal mit einer vorgegebenen Referenzperiodendauer empfangen wird. Hierbei wird das Sensortaktsignal mit dem Referenztaktsignal verglichen, wobei basierend auf dem Vergleich eine Abweichung der aktuellen Periodendauer des Sensortaktsignals von einer Sollperiodendauer ermittelt wird, und wobei basierend auf der ermittelten Abweichung ein Zählimpuls oder ein Rücksetzimpuls ausgegeben wird. Hierbei inkrementiert der Zählimpuls einen Fehlerzähler und der Rücksetzimpuls dekrementiert oder setzt den Fehlerzähler zurück. Der Fehlerzähler wird inkrementiert, wenn die Abweichung des Sensortaktsignals innerhalb eines Akzeptanzfensters und außerhalb eines vorgegebenen Optimalwertfensters liegt. Zudem wird der Fehlerzähler dekrementiert oder zurückgesetzt, wenn die Abweichung des Sensortaktsignals innerhalb des Akzeptanzfensters und innerhalb des vorgegebenen Optimalwertfensters liegt. Zudem wird ein Fehlersignal ausgegeben, wenn ein Fehlerzählerstand einen vorgegebenen Grenzwert erreicht oder übersteigt.

Zudem wird eine Vorrichtung zur Überwachung eines Sensortaktsignals in einer Sensoreinheit vorgeschlagen, welches ein Sensoroszillator mit einer vorgegebenen Periodendauer für eine Datenübertragung zwischen der Sensoreinheit und einem Steuergerät erzeugt und ausgibt. Ein Referenzoszillator erzeugt und gibt ein Referenztaktsignal mit einer vorgegebenen Referenzperiodendauer aus. Hierbei umfasst die Vorrichtung zur Überwachung eines Sensortaktsignals in einer Sensoreinheit einen Oszillatormonitor, welcher das Sensortaktsignal und das Referenztaktsignal empfängt und das Verfahren zur Überwachung eines Sensortaktsignals in einer Sensoreinheit ausführt. Hierbei inkrementiert der Zählimpuls einen Fehlerzähler und der Rücksetzimpuls dekrementiert oder setzt den Fehlerzähler zurück. Der Oszillatormonitor erzeugt den Zählimpuls, wenn die Abweichung des Sensortaktsignals innerhalb des Akzeptanzfensters und außerhalb des Optimalwertfensters liegt. Des Weiteren erzeugt der Oszillatormonitor den Rücksetzimpuls, wenn die Abweichung des Sensortaktsignals innerhalb des Akzeptanzfensters und innerhalb des Optimalwertfensters liegt. Zudem gibt der Oszillatormonitor ein Fehlersignal aus, wenn ein Fehlerzählerstand einen vorgegebenen Grenzwert erreicht oder übersteigt.

Die Kernidee der Erfindung besteht aus einem Vergleich des Sensortaktsignals mit einem Referenztaktsignal, welches beispielsweise gemäß PSI5 Protokoll vom Steuergerät an die Sensoreinheit übertragen und von der Sensoreinheit empfangen wird. Sofern die Abweichung des Sensortaktsignals einen vorgegebenen Prozentsatz überschreitet, sendet die Sensoreinheit ein entsprechendes Fehlersignal an das Steuergerät.

Unter der Vorrichtung zur Überwachung eines Sensortaktsignals in einer Sensoreinheit kann vorliegend eine in der Sensoreinheit angeordnete Auswerte- und Steuereinheit verstanden werden, welche erfasste Sensorsignale verarbeitet bzw. auswertet. Die Auswerte- und Steuereinheit kann mindestens eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen der Auswerte- und Steuereinheit, wie beispielsweise die Funktion des Oszillatormonitors beinhaltet. Es ist jedoch auch möglich, dass der Oszillatormonitor und/oder die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind. Von Vorteil ist auch ein Computerprogrammprodukt mit Programmcode, der auf einem maschinenlesbaren Träger wie einem Halbleiterspeicher, einem Festplattenspeicher oder einem optischen Speicher gespeichert ist und zur Durchführung der Auswertung verwendet wird, wenn das Programm von der Auswerte- und Steuereinheit ausgeführt wird.

Unter einer Sensoreinheit wird vorliegend eine Baueinheit verstanden, welche mindestens ein Sensorelement umfasst, welches eine physikalische Größe bzw. eine Änderung einer physikalischen Größe direkt oder indirekt erfasst und vorzugsweise in ein elektrisches Sensorsignal umwandelt. So kann die Sensoreinheit beispielsweise als Beschleunigungssensor oder als Drucksensor oder als Drehratensensor mit entsprechenden Sensorelementen ausgeführt werden. Die Sensoreinheit kann beispielsweise zur Detektion von Fußgängerunfällen in einem Fahrzeugstoßfänger verbaut werden. Für die Erkennung von Seitencrashes kann die Sensoreinheit bei einer Ausführung als Beschleunigungssensor an der B-, C- oder D- Säule des Fahrzeugs oder bei einer Ausführung als Drucksensor in der Fahrzeugtür verbaut werden. Für die Erkennung von Frontcrashs kann die Sensoreinheit als Beschleunigungssensor in einem Zentralsteuergerät oder entlang eines Biegequerträgers des Fahrzeugs verbaut werden. Für die Erkennung von Überschlägen bzw. Schleudern kann die Sensoreinheit als Drehratensensor im Zentralsteuergerät oder in einem separaten Gehäuse auf einem Fahrzeugmitteltunnel verbaut werden. Die von Sensoreinheiten ausgegebenen Signale werden von Algorithmen innerhalb des Steuergeräts weiterverarbeitet. Erkennt ein solcher Algorithmus, dass ein Fußgängeraufprall, ein Seitencrash, ein Frontcrash oder ein Überschlag stattgefunden hat, so wird in Abhängigkeit des erkannten Unfallszenarios eine Auslöseentscheidung für aktive Rückhaltemittel (z.B. Airbag) im Fahrzeug getroffen und diese Rückhaltemittel aktiviert, um bei einem Fußgängeraufprall den Fußgänger bzw. bei einem Crashfall die Fahrzeuginsassen zu schützen.

Durch die in den abhängigen Ansprüchen aufgeführten Maßnahmen und Weiterbildungen sind vorteilhafte Verbesserungen des im unabhängigen Patentanspruch 1 angegebenen Verfahrens zur Überwachung eines Sensortaktsignals in einer Sensoreinheit und der im unabhängigen Patentanspruch 3 angegebenen Vorrichtung zur Überwachung eines Sensortaktsignals in einer Sensoreinheit möglich.

Der Grenzwert für den Fehlerzähler kann beispielsweise in Abhängigkeit von einer Periode des Referenztaktsignals, der gewählten Inkrementierstufe und einer definierten Zeitspanne vorgegebenen werden, in welcher ein fehlerhaftes Sensortaktsignal erkannt werden sollte.

In vorteilhafter Ausgestaltung kann die erfindungsgemäße Vorrichtung einen Zähler umfassen, welcher Pulse des Sensortaktsignals zählt. Hierbei kann der Oszillatormonitor den Zähler an einem Startzeitpunkt starten, an welchem der Oszillatormonitor einen ersten Synchronisationspuls des Referenztaktsignals empfängt, und den Zähler an einem Stoppzeitpunkt anhalten, an welchem der Oszillatormonitor einen nachfolgenden zweiten Synchronisationspuls empfängt. Der Einsatz des Zählers ermöglicht eine besonders einfache und kostengünstige Implementierung der erfindungsgemäßen Vorrichtung zur Überwachung eines Sensortaktsignals in einer Sensoreinheit. So kann der Oszillatormonitor einen Zählerstand des Zählers auslesen und mit einem Sollzählerstand vergleichen, welcher aus dem Verhältnis von Referenzperiodendauer zu Sollperiodendauer des Sensortaktsignals berechnet ist. Der Sollzählerstand kann beispielsweise vom Oszillatormonitor oder vorab berechnet und in einem nichtflüchtigen Speicher in der Sensoreinheit gespeichert werden. Basierend auf dem Vergleich kann der Oszillatormonitor eine Abweichung der aktuellen Periodendauer des Sensortaktsignals von einer Sollperiodendauer ermitteln.

In weiterer vorteilhafter Ausgestaltung der erfindungsgemäßen Vorrichtung kann der Oszillatormonitor basierend auf einem vorgegebenen Toleranzbereich für die Abweichung des Sensortaktsignals das Akzeptanzfenster berechnen, welches nach unten durch einen ersten Zählerstand und nach oben durch einen zweiten Zählerstand begrenzt werden kann. Zudem kann der Oszillatormonitor basierend auf dem vorgegebenen Toleranzbereich für die Abweichung des Sensortaktsignals das Optimalwertfenster berechnen, welches nach unten durch einen dritten Zählerstand, welcher größer als der erste Zählerstand ist, und nach oben durch einen vierten Zählerstand begrenzt ist, welcher kleiner als der zweite Zählerstand ist.

In weiterer vorteilhafter Ausgestaltung der erfindungsgemäßen Vorrichtung kann der Oszillatormonitor den zweiten Synchronisationspuls als neuen ersten Synchronisationspuls interpretieren und den Zähler neu starten, wenn der ausgelesene aktuelle Zählerstand innerhalb des Akzeptanzfensters liegt. Zudem kann der Oszillatormonitor den zweiten Synchronisationspuls als Störimpuls interpretieren, wenn der korrespondierende ausgelesene aktuelle Zählerstand kleiner als der erste Zählerstand ist. In diesem Fall kann der Oszillatormonitor den als Störimpuls interpretierten zweiten Synchronisationspuls ignorieren und keine Änderung des Fehlerzählerstands und kein Neustart des Fehlerzählers durchführen. Des Weiteren kann der Oszillatormonitor den zweiten Synchronisationspuls als neuen ersten Synchronisationspuls interpretieren, wenn der korrespondierende ausgelesene aktuelle Zählerstand größer als der zweite Zählerstand ist. In diesem Fall kann der Oszillatormonitor in Reaktion auf den als neuer erster Synchronisationspuls interpretierten zweiten Synchronisationspuls den Zähler neu starten und keine Änderung des Fehlerzählerstands durchführen. Dadurch wird die Datenübertragung bei Ausführungsformen der vorliegenden Erfindung in vorteilhafter Weise noch robuster gegenüber EMV Störungen von außen, welche künstliche oder fehlende Synchronisationspulse bewirken können. Zudem kann dadurch in vorteilhafter Weise verhindert werden, dass eine EMV-Störung zu einer Änderung des Fehlerzählerstands führen kann.

Ausführungsbeispiele der Erfindung sind in der Zeichnung dargestellt und werden in der nachfolgenden Beschreibung näher erläutert. In der Zeichnung bezeichnen gleiche Bezugszeichen Komponenten bzw. Elemente, die gleiche bzw. analoge Funktionen ausführen.

Kurze Beschreibung der Zeichnungen

Fig. 1 zeigt ein schematisches Blockdiagramm einer Sensoranordnung in einem Fahrzeug.

Fig. 2 zeigt ein schematisches Blockdiagramm einer Sensoreinheit der Sensoranordnung aus Fig. 1 mit einem Ausführungsbeispiel einer erfindungsgemäßen Vorrichtung zur Überwachung eines Sensortaktsignals in einer Sensoreinheit.

Fig. 3 zeigt eine schematische Darstellung eines ersten Zeitstrahls für ein erfindungsgemäßes Verfahren zur Überwachung eines Sensortaktsignals in einer Sensoreinheit, wobei ein zweiter Synchronisationspuls innerhalb eines Akzeptanzfensters und innerhalb eines Optimalwertfensters empfangen wird.

Fig. 4 zeigt eine schematische Darstellung eines zweiten Zeitstrahls für ein erfindungsgemäßes Verfahren zur Überwachung eines Sensortaktsignals in einer Sensoreinheit, wobei der zweite Synchronisationspuls innerhalb des Akzeptanzfensters aber außerhalb des Optimalwertfensters empfangen wird.

Fig. 5 zeigt eine schematische Darstellung eines dritten Zeitstrahls für das erfindungsgemäße Verfahren zur Überwachung eines Sensortaktsignals in einer Sensoreinheit, wobei der zweite Synchronisationspuls vor dem Akzeptanzfenster empfangen wird.

Fig. 6 zeigt eine schematische Darstellung eines vierten Zeitstrahls für das erfindungsgemäße Verfahren zur Überwachung eines Sensortaktsignals in einer Sensoreinheit, wobei der zweite Synchronisationspuls nach dem Akzeptanzfenster empfangen wird.

Fig. 7 zeigt eine schematische Darstellung eines Zählvorgangs eines ersten Ausführungsbeispiels eines Fehlerzählers für die erfindungsgemäße Vorrichtung zur Überwachung eines Sensortaktsignals in einer Sensoreinheit aus Fig. 2.

Fig. 8 zeigt eine schematische Darstellung eines Zählvorgangs eines zweiten Ausführungsbeispiels eines Fehlerzählers für die erfindungsgemäße Vorrichtung zur Überwachung eines Sensortaktsignals in einer Sensoreinheit aus Fig. 2.

Ausführungsformen der Erfindung

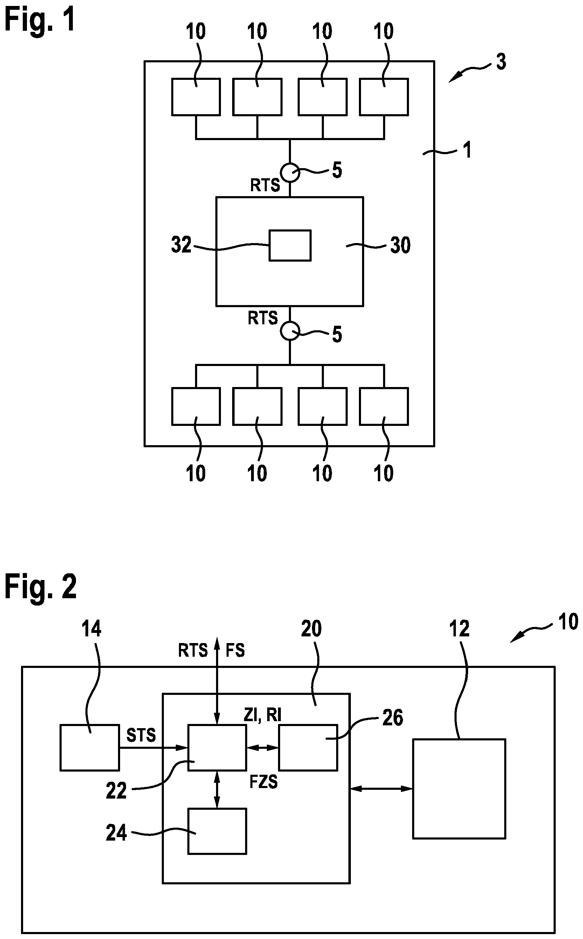

Wie aus Fig. 1 und 2 ersichtlich ist, umfasst eine Sensoranordnung 3 für ein Fahrzeug 1 im dargestellten Ausführungsbeispiel ein Steuergerät 30 mit einem Referenzoszillator 32, welcher ein Referenztaktsignal RTS mit einer vorgegebenen Referenzperiodendauer T_ref erzeugt und ausgibt, mehrere Busknoten 5, von denen zwei Busknoten 5 dargestellt sind und mehrere Sensoreinheiten 10, welche jeweils als periphere Airbagsensoren ausgeführt und mit einem der Busknoten 5 verbunden sind. Im dargestellten Ausführungsbeispiel sind jeweils vier Sensoreinheiten 10 mit einem der Busknoten 5 verbunden. In der dargestellten Sensoranordnung 3, welche Teil eines Personenschutzsystems des Fahrzeugs 1 ist, sind die einzelnen Sensoreinheiten 10, Busknoten 5 und das Steuergerät 30 über strommodulierte Zweidrahtbusse miteinander verbunden und kommunizieren über den PSI5 Standard. Dadurch kann das Steuergerät 30 die von den Sensoreinheiten 10 erfassten Druck- oder Beschleunigungsdaten oder Drehratendaten empfangen und auswerten.

Wie aus Fig. 1 und 2 weiter ersichtlich ist, umfassen die einzelnen Sensoreinheiten 10 jeweils ein Sensorelement 12, einen Sensoroszillator 14, welcher ein Sensortaktsignal STS mit einer vorgegebenen Periodendauer T_STS erzeugt und ausgibt, und eine Vorrichtung 20 zur Überwachung eines Sensortaktsignals STS in einer Sensoreinheit 10.

Im dargestellten Ausführungsbeispiel ist die Vorrichtung 20 zur Überwachung eines Sensortaktsignals STS in einer Sensoreinheit 10 als anwendungsspezifische integrierte Schaltung (ASIC) ausgeführt, welche mindestens eine Rechnereinheit bzw. mindestens einen Mikrocontroller umfasst und erfasste Sensorsignale verarbeitet und auswertet.

Wie aus Fig. 2 weiter ersichtlich ist, umfasst die Vorrichtung 20 zur Überwachung eines Sensortaktsignals STS in einer Sensoreinheit 10 einen Oszillatormonitor 22, welcher das Sensortaktsignal STS und das Referenztaktsignal RTS empfängt und ein erfindungsgemäßes Verfahren zur Überwachung eines Sensortaktsignals STS in einer Sensoreinheit 10 ausführt. Hierbei wird das Sensortaktsignal STS in einem ersten Schritt mit dem Referenztaktsignal RTS verglichen, wobei basierend auf dem Vergleich eine Abweichung Delta_t der aktuellen Periodendauer T_STS des Sensortaktsignals STS von einer Sollperiodendauer T_STS soll ermittelt wird. Basierend auf der ermittelten Abweichung Delta_t wird dann ein Zählimpuls ZI oder ein Rücksetzimpuls RI ausgegeben.

Das Verfahren zur Überwachung eines Sensortaktsignals STS in einer Sensoreinheit 10 kann beispielsweise in Software oder Hardware oder in einer Mischform aus Software und Hardware in den einzelnen Sensoreinheiten 10 implementiert sein.

Im dargestellten Ausführungsbeispiel weist das Referenztaktsignal RTS eine Frequenz von 2kHz und eine Referenzperiodendauer T_ref von $500\mu s \pm 1\%$ auf. Das Sensortaktsignal STS weist im dargestellten Ausführungsbeispiel eine Frequenz von 18MHz und eine Sollperiodendauer T_STS_soll von $0,0555\mu s$ auf. Für die Erkennung der Abweichung Delta_t des Sensortaktsignals STS der Sensoreinheit 10 relativ zum Referenztaktsignal RTS des Steuergeräts 30 wird somit die Abweichung Delta_t gemäß Gleichung (1) berechnet.

$$Delta\_t = T\_ref - N * T\_STS \text{ mit } N = T\_ref / T\_STS\_soll \quad (1)$$

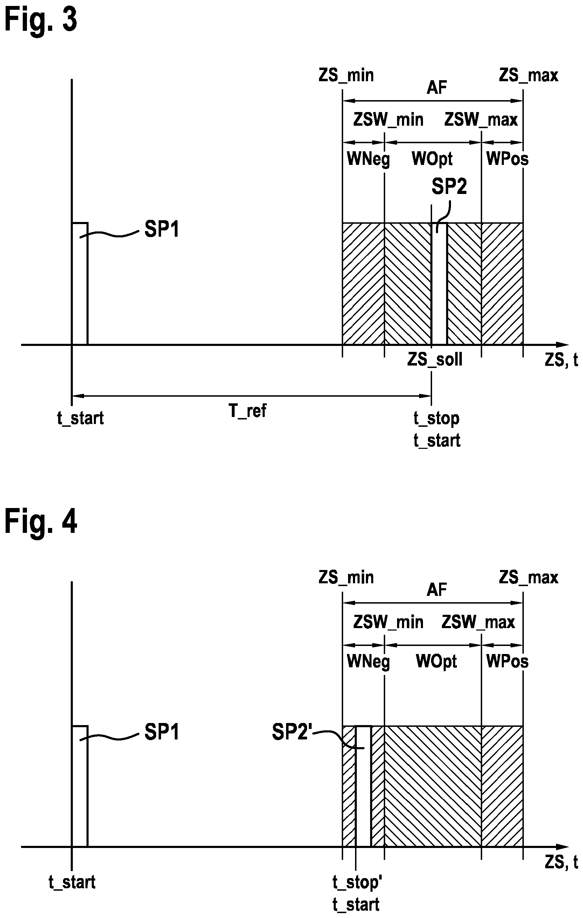

Für die oben angegebenen Werte ergibt sich für den Faktor N ein Wert von 9.000. Typische Toleranzen des Sensortaktsignals STS über Lebensdauer liegen bei ± 3,5 %. Die erlaubte obere Grenze für Abweichungen Delta_t des Sensortaktsignals STS der Sensoreinheit 10 liegt gemäß PSI5 Standard bei ± 5 %. Die Toleranz des Referenztaktsignals liegt bei ± 1 %. Ein in Fig. 3 bis 6 dargestelltes Optimalwertfenster WOpt, welches einen erlaubten Bereich für die Abweichung Delta_t des Sensortaktsignals STS vorgibt, kann somit mit einem zusätzlichen Sicherheitsabstand vorgegeben werden.

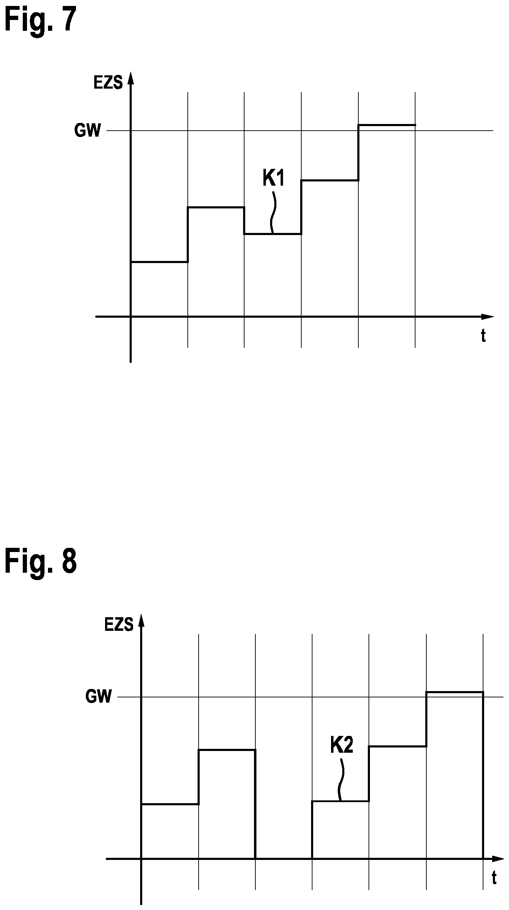

Ein in Fig. 3 bis 6 dargestelltes Akzeptanzfenster AF kann beispielsweise mit einer äußeren Grenze von ± 10 % vorgegeben werden. Die äußere Grenze des beispielhaften Akzeptanzfensters AF ergibt sich aus der Toleranz des Sensoroszillators 14 von ± 5 %, der Toleranz des Referenztaktsignals RTS von ± 1 % und dem Sicherheitsabstand, der beispielhaft einen Wert von ± 4 % aufweist. Für die Erkennung von fehlerhaften Abweichungen Delta_t des Sensortaktsignals STS kommen somit Bereiche in Frage, welche außerhalb des erlaubten Abweichungsbereichs bzw. des Optimalwertfensters WOpt aber innerhalb des Akzeptanzfensters AF liegen. Innere Grenzen dieser Bereiche für die Fehlererkennung können beispielsweise bei einer Abweichung Delta_t des Sensortaktsignals STS von ± 7 % bis 8 % liegen. Die Außengrenzen des Akzeptanzfensters AF liegen typischerweise bei einer Abweichung Delta_t des Sensortaktsignals STS von ca. ± 10 %. Mit diesem Zahlenbeispiel kann eine fehlerhafte Abweichung Delta_t des Sensortaktsignals STS in negativer Richtung zwischen - 7 % und - 10 % in einem negativen Fehlerfenster WNeg erkannt werden, während eine fehlerhafte Abweichung Delta_t des Sensortaktsignals STS in positiver Richtung zwischen + 7 % und 10 % in einem positiven Fehlerfenster WPos erkannt werden kann. Die 7 % bis 8 % als innere Grenze der Fehlererkennung setzen sich aus der erlaubten Toleranz des Sensoroszillators 14 von ± 5 %, der Toleranz des Referenztaktsignals RTS von ± 1 % und dem Sicherheitsabstand zusammen, der beispielhaft einen Wert von ± 1 bis 2 % aufweist. Befindet sich das erfasste Sensortaktsignal STS beispielsweise im negativen Fehlerfenster WNeg oder im positiven Fehlerfenster WPos, so wird nicht sofort das Fehlersignal FS ausgegeben, sondern stattdessen der Zählimpuls ZI ausgegeben, der im dargestellten Ausführungsbeispiel einen Fehlerzähler 26 inkrementiert. Erst wenn der Fehlerzähler 26 einen in Fig. 7 und 8 dargestellten Grenzwert GW überschreitet, wird das Fehlersignal FS in der Sensoreinheit 10 erzeugt und an das Steuergerät 30 übertragen. Befindet sich das erfasste Sensortaktsignal STS beispielsweise im Optimalwertfenster WOpt, dann wird im dargestellten Ausführungsbeispiel der Rücksetzimpuls RI erzeugt und ausgegeben, welcher den Fehlerzähler 26 dekrementieren oder zurücksetzen kann. Das bedeutet, dass der Fehlerzähler 26 inkrementiert wird, wenn die Abweichung Delta_t innerhalb des Akzeptanzfensters AF und außerhalb eines vorgegebenen Optimalwertfensters WOpt liegt, und der Fehlerzähler 26 dekrementiert oder zurückgesetzt wird, wenn die Abweichung Delta_t innerhalb des Akzeptanzfensters AF und innerhalb des vorgegebenen Optimalwertfensters WOpt liegt.

Der Fehlerzähler 26 ist im dargestellten Ausführungsbeispiel als 16Bit Variable ausgelegt. Der Fehlerzähler 26 zählt die Anzahl der Zyklen, in welchen die Abweichung Delta_t innerhalb des Akzeptanzfensters AF und außerhalb des vorgegebenen Optimalwertfensters WOpt liegt. Der Fehlerzähler 26 kann in jedem relevanten Zyklus mit unterschiedlichen Stufen inkrementiert werden. Beim Dekrementieren kann der Fehlerzähler 26 ebenfalls unterschiedliche Stufen verwenden. Der Grenzwert GW für den Fehlerzähler 26 kann beispielsweise in Abhängigkeit von einer Periode T_ref des Referenztaktsignals RTS, der gewählten Inkrementierstufe und einer definierten Zeitspanne vorgegebenen werden, in welcher ein fehlerhaftes Sensortaktsignal STS erkannt werden sollte.

Wie aus Fig. 7 weiter ersichtlich ist, wird im dargestellten Ausführungsbeispiel eine Inkrementierstufe und eine Dekrementierstufe des Fehlerzählers 26 vorgegeben, wobei die Dekrementierstufe kleiner als die Inkrementierstufe vorgegeben ist. Wie aus Fig. 7 weiter ersichtlich ist, wird der Fehlerzähler 26 in der dargestellten Kennlinie K1 zweimal inkrementiert, dann einmal dekrementiert und dann wieder zweimal inkrementiert. Das Fehlersignal FS wird erst ausgegeben, wenn ein Fehlerzählerstand FZS den vorgegebenen Grenzwert GW erreicht oder übersteigt.

Wie aus Fig. 8 weiter ersichtlich ist, wird im dargestellten Ausführungsbeispiel eine Inkrementierstufe des Fehlerzählers 26 vorgegeben, wobei der Fehlerzähler 26 im dargestellten Ausführungsbeispiel nicht dekrementiert sondern zurückgesetzt wird, wenn die Abweichung Delta_t innerhalb des Akzeptanzfensters AF und innerhalb des vorgegebenen Optimalwertfensters WOpt liegt. Wie aus Fig. 8 weiter ersichtlich ist, wird der Fehlerzähler 26 in der dargestellten Kennlinie K2 zweimal inkrementiert, dann einmal zurückgesetzt und dann wieder dreimal inkrementiert. Das Fehlersignal FS wird erst ausgegeben, wenn ein Fehlerzählerstand FZS den vorgegebenen Grenzwert GW erreicht oder übersteigt.

Durch den Fehlerzähler 26 kann in vorteilhafter Weise verhindert werden, dass einmalige Ereignisse, wie Störimpulses oder fehlerhafte Synchronisationspulse, die Erzeugung und Ausgabe eines Fehlersignals bewirken.

Im dargestellten Ausführungsbeispiel umfasst die Vorrichtung 20 zur Überwachung eines Sensortaktsignals STS in einer Sensoreinheit 10 einen Zähler 24, welcher Pulse des Sensortaktsignals STS zählt. Nachfolgend wird unter Bezugnahme auf Fig. 3 bis 6 die Funktionsweise der Vorrichtung 20 zur Überwachung eines Sensortaktsignals STS in einer Sensoreinheit 10 aus Fig. 2 beschrieben. Der Oszillatormonitor 22 startet den Zähler 24 an einem Startzeitpunkt t_start, t_start‴, an welchem der Oszillatormonitor 22 einen ersten Synchronisationspuls SP1 des Referenztaktsignals RTS empfängt. Der Oszillatormonitor 22 hält den Zähler 24 an einem Stoppzeitpunkt t_stop, t_stop', t_stop", t_stop‴ an, an welchem der Oszillatormonitor 22 einen nachfolgenden zweiten Synchronisationspuls SP2, SP2', SP2", SP2‴ empfängt. Der Oszillatormonitor 22 liest dann einen Zählerstand ZS des Zählers 24 aus und vergleicht diesen mit einem Sollzählerstand ZS_soll, welcher aus dem Verhältnis von Referenzperiodendauer T_ref zu Sollperiodendauer T_STS soll des Sensortaktsignals STS berechnet ist. Mit den o.g. Werten ergibt sich ein Sollzählerstand ZS_soll von 9.000. Somit kann der Oszillatormonitor 22 basierend auf einem Vergleich des Sollzählerstands ZS_soll und des aktuellen Zählerstands ZS die Abweichung Delta_t der aktuellen Periodendauer T_STS des Sensortaktsignals STS von der Sollperiodendauer T_STS soll gemäß Gleichung (2) ermitteln.

$$\text{Delta\_t} = (\text{ZS\_soll} - \text{ZS}) * \text{T\_STS\_soll} \qquad (2)$$

Basierend auf dem vorgegebenen Toleranzbereich von $\pm 10\%$ für die Abweichung Delta_t berechnet der Oszillatormonitor 22 das Akzeptanzfenster AF, welches nach unten durch einen ersten Zählerstand ZS_min von hier 8.100 und nach oben durch einen zweiten Zählerstand ZS_max von hier 9.900 begrenzt ist. Zudem berechnet der Oszillatormonitor 22 das Optimalwertfenster WOpt, welches nach unten durch einen dritten Zählerstand ZSW_min von hier 8.370 und nach oben durch einen vierten Zählerstand ZSW_max von hier 9.630 begrenzt ist. Somit weist das negative Fehlerfenster WNeg als untere Grenze den ersten Zählerstand ZS_min von 8.100 und als obere Grenze den dritten Zählerstand ZSW_min von 8.370 auf. Das positive Fehlerfenster WPos weist als untere Grenze den vierten Zählerstand ZSW_max von 9.630 und als obere Grenze den zweiten Zählerstand ZS_max von 9.900 auf.

Wie aus Fig. 3 weiter ersichtlich ist, empfängt der Oszillatormonitor 22 zum Startzeitpunkt t_start den ersten Synchronisationspuls SP1 und startet den Zähler 24. Zum Stoppzeitpunkt t_stop empfängt der Oszillatormonitor 22 den zweiten Synchronisationspuls SP2 innerhalb des Akzeptanzfensters AF und innerhalb des Optimalwertfensters WOpt. Das bedeutet, dass der ausgelesene aktuelle Zählerstand ZS zwischen dem dritten Zählerstand ZSW_min von hier 8.370 und dem vierten Zählerstand ZSW_max von hier 9.630 liegt. Daher interpretiert der Oszillatormonitor 22 die beiden Synchronisationspulse SP1, SP2 als gültiges Synchronisationspulspaar. Da Fig. 3 einen optimalen Zustand mit einer Abweichung Delta_t von 0 zeigt, entspricht der ausgelesene aktuelle Zählerstand ZS dem Sollzählerstand ZS_soll. Da die Abweichung Delta_t innerhalb des Akzeptanzfensters AF und innerhalb des Optimalwertfensters WOpt liegt, erzeugt der Oszillatormonitor 22 den Rücksetzimpuls RI für den Fehlerzähler 26. In Abhängigkeit von der Ausführung des Fehlerzählers 26 wird daher der Fehlerzählerstand FZS dekrementiert oder zurückgesetzt. Zudem interpretiert der Oszillatormonitor 22 den zweiten Synchronisationspuls SP2 als neuen ersten Synchronisationspuls SP1 und startet den Zähler 24 neu.

Wie aus Fig. 4 weiter ersichtlich ist, empfängt der Oszillatormonitor 22 zum Startzeitpunkt t_start den ersten Synchronisationspuls SP1 und startet den Zähler 24. Zum Stoppzeitpunkt t_stop empfängt der Oszillatormonitor 22 den zweiten Synchronisationspuls SP2' innerhalb des Akzeptanzfensters AF aber außerhalb des Optimalwertfensters WOpt. In der Darstellung liegt der zweite Synchronisationspuls SP2' innerhalb des negativen Fehlerfensters WNeg. Das bedeutet, dass der ausgelesene aktuelle Zählerstand ZS zwischen dem ersten Zählerstand ZS_min von hier 8.100 und dem dritten Zählerstand ZSW_min von hier 8.370 liegt. Daher interpretiert der Oszillatormonitor 22 die beiden Synchronisationspulse SP1, SP2 als gültiges Synchronisationspulspaar. Da die Abweichung Delta_t innerhalb des negativen Fehlerfensters WNeg, d.h. innerhalb des Akzeptanzfensters AF aber außerhalb des Optimalwertfensters WOpt liegt, erzeugt der Oszillatormonitor 22 den Zählimpuls ZI für den Fehlerzähler 26. Daher inkrementiert der Fehlerzähler 26 den Fehlerzählerstand FZS. Der Oszillatormonitor 22 überprüft, ob der aktuelle Fehlerzählerstand FZS den vorgegebenen Grenzwert GW erreicht oder überschritten hat. Ist dies der Fall, dann erzeugt der Oszillatormonitor 22 das Fehlersignal FS und gibt es an das Steuergerät 30 aus. Da der ausgelesene aktuelle Zählerstand ZS innerhalb des Akzeptanzfensters AF liegt, interpretiert der Oszillatormonitor 22 den zweiten Synchronisationspuls SP2' als neuen ersten Synchronisationspuls SP1 und startet den Zähler 24 neu.

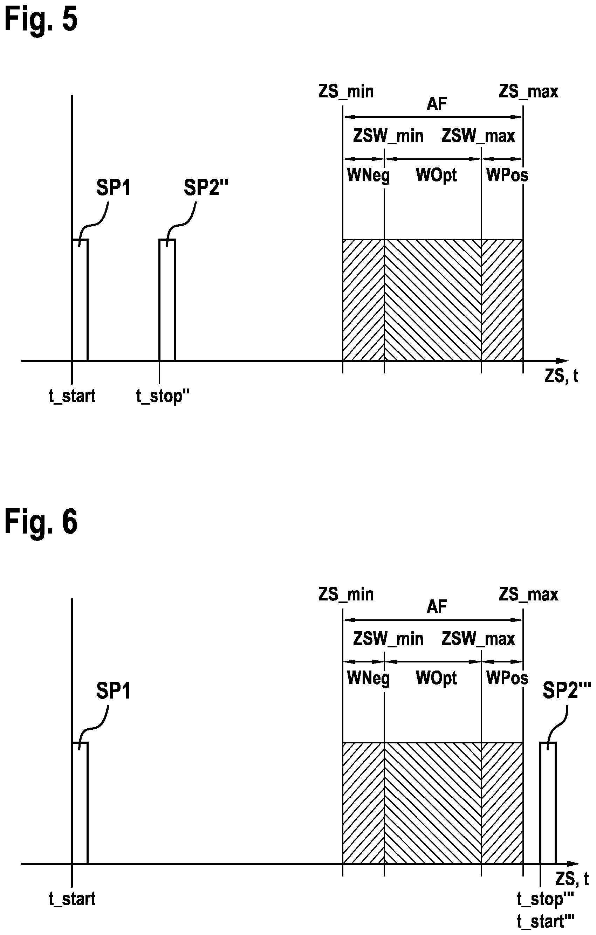

Wie aus Fig. 5 weiter ersichtlich ist, empfängt der Oszillatormonitor 22 zum Startzeitpunkt t_start den ersten Synchronisationspuls SP1 und startet den Zähler 24. Zum Stoppzeitpunkt t_stop" empfängt der Oszillatormonitor 22 den zweiten Synchronisationspuls SP2" außerhalb des Akzeptanzfensters AF. Bei der Darstellung gemäß Fig. 5 liegt der ausgelesene Zählerstand ZS unter dem ersten Zählerstand ZS_min von hier 8.100. Daher interpretiert der Oszillatormonitor 22 den zweiten Synchronisationspuls SP2" als Störimpuls und die beiden Synchronisationspulse SP1, SP2" als ungültiges Synchronisationspulspaar. Da es sich in diesem Fall um einen Störimpuls handelt, wird dieser vom Oszillatormonitor 22 ignoriert und es erfolgt keine Änderung des Fehlerzählerstands FZS und auch kein Neustart des Zählers 24.

Wie aus Fig. 6 weiter ersichtlich ist, empfängt der Oszillatormonitor 22 zum Startzeitpunkt t_start den ersten Synchronisationspuls SP1 und startet den Zähler 24. Zum Stoppzeitpunkt t_stop''' empfängt der Oszillatormonitor 22 den zweiten Synchronisationspuls SP2''' außerhalb des Akzeptanzfensters AF. Bei der Darstellung gemäß Fig. 6 liegt der ausgelesene Zählerstand ZS über dem zweiten Zählerstand ZS_max von hier 9.900. In diesem Fall wird der empfangene zweite Synchronisationspuls SP2''' vom Oszillatormonitor 22 akzeptiert. Der Oszillatormonitor 22 interpretiert jedoch den zweiten Synchronisationspuls SP2''' als neuen ersten Synchronisationspuls SP1. Das bedeutet der zweite Synchronisationspuls SP2''' dient als neuer Startzeitpunkt t_start für die Referenztaktmessung bzw. für den Zähler 24 in der Sensoreinheit 10. Es erfolgt aber keine Änderung des Fehlerzählerstands FZS.

Ausführungsformen der vorliegenden Erfindung bieten den weiteren Vorteil, dass die Ausgabe eines Fehlersignals noch robuster gegenüber EMV Störungen von außen ist. Schließlich soll im Fall einer EMV Störung kein Fehlersignal ausgegeben werden.


**Patentansprüche**

1. Verfahren zur Überwachung eines Sensortaktsignals (STS) in einer Sensoreinheit (10), welches für eine Datenübertragung zwischen der Sensoreinheit (10) und einem Steuergerät (30) mit einer vorgegebenen Periodendauer (T_STS) erzeugt und ausgegeben wird, wobei ein Referenztaktsignal (RTS) mit einer vorgegebenen Referenzperiodendauer (T_ref) empfangen wird, wobei das Sensortaktsignal (STS) mit dem Referenztaktsignal (RTS) verglichen wird, wobei basierend auf dem Vergleich eine Abweichung (Delta_t) der aktuellen Periodendauer (T_STS) des Sensortaktsignals (STS) von einer Sollperiodendauer (T_STS_soll) ermittelt wird, und wobei basierend auf der ermittelten Abweichung (Delta_t) ein Zählimpuls (ZI) oder ein Rücksetzimpuls (RI) ausgegeben wird, **dadurch gekennzeichnet, dass** der Zählimpuls (ZI) einen Fehlerzähler (26) inkrementiert und der Rücksetzimpuls (RI) den Fehlerzähler (26) dekrementiert oder zurücksetzt, wobei der Fehlerzähler (26) inkrementiert wird, wenn die Abweichung (Delta_t) innerhalb eines Akzeptanzfensters (AF) und außerhalb eines vorgegebenen Optimalwertfensters (WOpt) liegt, wobei der Fehlerzähler (26) dekrementiert oder zurückgesetzt wird, wenn die Abweichung (Delta_t) innerhalb des Akzeptanzfensters (AF) und innerhalb des vorgegebenen Optimalwertfensters (WOpt) liegt, und wobei ein Fehlersignal (FS) ausgegeben wird, wenn ein Fehlerzählerstand (FZS) einen vorgegebenen Grenzwert (GW) erreicht oder übersteigt.

2. Verfahren nach Anspruch 1, **dadurch gekennzeichnet, dass** eine Inkrementierstufe und/oder eine Dekrementierstufe des Fehlerzählers (26) vorgegeben werden.

3. Vorrichtung (20) zur Überwachung eines Sensortaktsignals (STS) in einer Sensoreinheit (10), welches ein Sensoroszillator (14) mit einer vorgegebenen Periodendauer (T_STS) für eine Datenübertragung zwischen der Sensoreinheit (10) und einem Steuergerät (30) erzeugt und ausgibt, wobei ein Referenzoszillator (32) ein Referenztaktsignal (RTS) mit einer vorgegebenen Referenzperiodendauer (T_ref) erzeugt und ausgibt, wobei ein Oszillatormonitor (22) das Sensortaktsignal (STS) und das Referenztaktsignal (RTS) empfängt und miteinander vergleicht und basierend auf dem Vergleich eine Abweichung (Delta_t) der aktuellen Periodendauer (T_STS) von einer Sollperiodendauer (T_STS_soll) ermittelt und basierend auf der ermittelten Abweichung (Delta_t) einen Zählimpuls (ZI) oder einen Rücksetzimpuls (RI) ausgibt, **dadurch gekennzeichnet, dass** der Zählimpuls (ZI) einen Fehlerzähler (26) inkrementiert und der Rücksetzimpuls (RI) den Fehlerzähler (26) dekrementiert oder zurücksetzt, wobei der Oszillatormonitor (22) den Zählimpuls (ZI) erzeugt, wenn die Abweichung (Delta_t) innerhalb eines Akzeptanzfensters (AF) und außerhalb eines vorgegebenen Optimalwertfensters (WOpt) liegt, wobei der Oszillatormonitor (22) den Rücksetzimpuls (RI) erzeugt, wenn die Abweichung (Delta_t) innerhalb des Akzeptanzfensters (AF) und innerhalb des vorgegebenen Optimalwertfensters (WOpt) liegt, und wobei der Oszillatormonitor (22) ein Fehlersignal (FS) ausgibt, wenn ein Fehlerzählerstand (FZS) des Fehlerzählers (26) einen vorgegebenen Grenzwert (GW) erreicht oder übersteigt.

4. Vorrichtung (20) nach Anspruch 3, **gekennzeichnet durch** einen Zähler (24), welcher Pulse des Sensortaktsignals (STS) zählt, wobei der Oszillatormonitor (22) den Zähler (24) an einem Startzeitpunkt (t_start, t_start''') startet, an welchem der Oszillatormonitor (22) einen ersten Synchronisationspuls (SP1) des Referenztaktsignals (RTS) empfängt, und den Zähler (24) an einem Stoppzeitpunkt (t_stop, t_stop', t_stop") anhält, an welchem der Oszillatormonitor (22) einen nachfolgenden zweiten Synchronisationspuls (SP2, SP2', SP2", SP2''') empfängt.

5. Vorrichtung (20) nach Anspruch 4, **dadurch gekennzeichnet, dass** der Oszillatormonitor (22) einen Zählerstand (ZS) des Zählers (24) ausliest und mit einem Sollzählerstand (ZS_soll) vergleicht, welcher aus dem Verhältnis von Referenzperiodendauer (T_ref) zu Sollperiodendauer (T_STS_soll) des Sensortaktsignals (STS) berechnet ist.

6.  Vorrichtung (20) nach einem der Ansprüche 3-5, **dadurch gekennzeichnet, dass** der Oszillatormonitor (22) basierend auf einem vorgegebenen Toleranzbereich für die Abweichung (Delta_t) das Akzeptanzfenster (AF) berechnet, welches nach unten durch einen ersten Zählerstand (ZS_min) und nach oben durch einen zweiten Zählerstand (ZS_max) begrenzt ist.

7.  Vorrichtung (20) nach Anspruch 6, **dadurch gekennzeichnet, dass** der Oszillatormonitor (22) basierend auf dem vorgegebenen Toleranzbereich für die Abweichung (Delta_t) das Optimalwertfenster (AF) berechnet, welches nach unten durch einen dritten Zählerstand (ZSW_min), welcher größer als der erste Zählerstand (ZS_min) ist, und nach oben durch einen vierten Zählerstand (ZSW_max) begrenzt ist, welcher kleiner als der zweite Zählerstand (ZS_max) ist.

8.  Vorrichtung (20) nach einem der Ansprüche 4 bis 7, **dadurch gekennzeichnet, dass** der Oszillatormonitor (22) den zweiten Synchronisationspuls (SP2) als neuen ersten Synchronisationspuls (SP1) interpretiert und den Zähler (24) neu startet, wenn der ausgelesene aktuelle Zählerstand (ZS) innerhalb des Akzeptanzfensters (AF) liegt.

9.  Vorrichtung (20) nach einem der Ansprüche 4 bis 8, **dadurch gekennzeichnet, dass** der Oszillatormonitor (22) den zweiten Synchronisationspuls (SP2'') als Störimpuls interpretiert, wenn der korrespondierende ausgelesene aktuelle Zählerstand (ZS) kleiner als der erste Zählerstand (ZS_min) ist.

10. Vorrichtung (20) nach Anspruch 9, **dadurch gekennzeichnet, dass** der Oszillatormonitor (22) den als Störimpuls interpretierten zweiten Synchronisationspuls (SP2'') ignoriert und keine Änderung des Fehlerzählers (26) durchführt.

11. Vorrichtung (20) nach einem der Ansprüche 4 bis 10, **dadurch gekennzeichnet, dass** der Oszillatormonitor (22) den zweiten Synchronisationspuls (SP2''') als neuen ersten Synchronisationspuls (SP1) interpretiert, wenn der korrespondierende ausgelesene aktuelle Zählerstand (ZS) größer als der zweite Zählerstand (ZS_max) ist.

12. Vorrichtung (20) nach Anspruch 11, **dadurch gekennzeichnet, dass** der Oszillatormonitor (22) in Reaktion auf den als neuer erster Synchronisationspuls (SP1) interpretierten zweiten Synchronisationspuls (SP2''') den Zähler (24) neu startet und keine Änderung des Fehlerzählers (26) durchführt.

**Claims**

1.  Method for monitoring a sensor clock signal (STS) in a sensor unit (10), which is generated and output with a predetermined period duration (T_STS) for data transfer between the sensor unit (10) and a control unit (30), wherein a reference clock signal (RTS) with a predetermined reference period duration (T_ref) is received, wherein the sensor clock signal (STS) is compared with the reference clock signal (RTS), wherein a deviation (Delta _t) of the current period duration (T_STS) of the sensor clock signal (STS) from a target period duration (T_STS_soll) is determined based on the comparison, and wherein a counting pulse (ZI) or a reset pulse (RI) is output based on the determined deviation (Delta_t), **characterized in that** the counting pulse (ZI) increments an error counter (26) and the reset pulse (RI) decrements or resets the error counter (26), wherein the error counter (26) is incremented if the deviation (Delta_t) is within an acceptance window (AF) and outside a predetermined optimal value window (WOpt), wherein the error counter (26) is decremented or reset if the deviation (Delta _t) is within the acceptance window (AF) and within the predetermined optimal value window (WOpt), and wherein an error signal (FS) is output when an error counter value (FZS) reaches or exceeds a predetermined limit value (GW).

2.  Method according to Claim 1, **characterized in that** an incrementing step and/or a decrementing step of the error counter (26) are predetermined.

3.  Device (20) for monitoring a sensor clock signal (STS) in a sensor unit (10), which a sensor oscillator (14) generates and outputs with a predetermined period duration (T_STS) for data transfer between the sensor unit (10) and a control unit (30), wherein a reference oscillator (32) generates and outputs a reference clock signal (RTS) with a predetermined reference period duration (T_ref), wherein an oscillator monitor (22) receives the sensor clock signal (STS) and the reference clock signal (RTS) and compares them with one another and determines a deviation (Delta _t) of the current period duration (T_STS) from a target period duration (T_STS_soll) based on the comparison and outputs a counting pulse (ZI) or a reset pulse (RI) based on the determined deviation (Delta_t), **characterized in that** the counting pulse (ZI) increments an error counter (26) and the reset pulse (RI) decrements or resets the error counter (26), wherein the oscillator monitor (22) generates the counting pulse (ZI) if the deviation (Delta_t) is within an acceptance window (AF) and outside a predetermined optimal value window (WOpt), wherein the oscillator monitor (22) generates the reset pulse (RI) if the deviation (Delta _t) is within the acceptance window (AF) and within the predetermined optimal value window (WOpt), and wherein the oscillator monitor (22) outputs an error signal (FS) when an error counter value (FZS) of the error counter (26) reaches or exceeds a predetermined limit value (GW).

4. Device (20) according to Claim 3, **characterized by** a counter (24), which counts pulses of the sensor clock signal (STS), wherein the oscillator monitor (22) starts the counter (24) at a start time (t_start, t_start‴), at which the oscillator monitor (22) receives a first synchronization pulse (SP1) of the reference clock signal (RTS), and stops the counter (24) at a stop time (t_stop, t_stop', t_stop''), at which the oscillator monitor (22) receives a subsequent, second synchronization pulse (SP2, SP2', SP2'', SP2‴).

5. Device (20) according to Claim 4, **characterized in that** the oscillator monitor (22) reads out a counter value (ZS) of the counter (24) and compares it with a target counter value (ZS_soll), which is calculated from the ratio of the reference period duration (T_ref) to the target period duration (T_STS_soll) of the sensor clock signal (STS).

6. Device (20) according to one of Claims 3-5, **characterized in that** the oscillator monitor (22) calculates the acceptance window (AF), which is limited downwards by a first counter value (ZS_min) and is limited upwards by a second counter value (ZS_max), based on a predetermined tolerance range for the deviation (Delta_t).

7. Device (20) according to Claim 6, **characterized in that** the oscillator monitor (22) calculates the optimal value window (AF), which is limited downwards by a third counter value (ZSW_min), which is greater than the first counter value (ZS_min), and is limited upwards by a fourth counter value (ZSW_max), which is less than the second counter value (ZS_max), based on the predetermined tolerance range for the deviation (Delta_t).

8. Device (20) according to one of Claims 4 to 7, **characterized in that** the oscillator monitor (22) interprets the second synchronization pulse (SP2) as the new first synchronization pulse (SP1) and restarts the counter (24) when the current counter value (ZS) that is read out is within the acceptance window (AF).

9. Device (20) according to one of Claims 4 to 8, **characterized in that** the oscillator monitor (22) interprets the second synchronization pulse (SP2'') as an interference pulse if the corresponding current counter value (ZS) that is read out is less than the first counter value (ZS_min).

10. Device (20) according to Claim 9, **characterized in that** the oscillator monitor (22) ignores the second synchronization pulse (SP2'') interpreted as an interference pulse and does not change the error counter (26) .

11. Device (20) according to one of Claims 4 to 10, **characterized in that** the oscillator monitor (22) interprets the second synchronization pulse (SP2‴) as the new first synchronization pulse (SP1) if the corresponding current counter value (ZS) that is read out is greater than the second counter value (ZS_max).

12. Device (20) according to Claim 11, **characterized in that**, in response to the second synchronization pulse (SP2‴) interpreted as the new first synchronization pulse (SP1), the oscillator monitor (22) restarts the counter (24) and does not change the error counter (26).

**Revendications**

1. Procédé permettant de surveiller un signal de synchronisation de capteur (STS) dans une unité de capteur (10), qui est généré et émis pour une transmission de données entre l'unité de capteur (10) et un appareil de commande (30) avec une durée de période prédéfinie (T_STS), dans lequel un signal de synchronisation de référence (RTS) avec une durée de période de référence prédéfinie (T_ref) est reçu, dans lequel le signal de synchronisation (STS) est comparé avec le signal de synchronisation de référence (RTS), dans lequel, sur la base de la comparaison, un écart (Delta _t) de la durée de période actuelle (T_STS) du signal de synchronisation de capteur (STS) par rapport à une durée de période théorique (T_STS_soll) est établi, et dans lequel, sur la base de l'écart (Delta_t) établi, une impulsion de compteur (ZI) ou une impulsion de réinitialisation (RI) est émise, **caractérisé en ce que** l'impulsion de compteur (ZI) incrémente un compteur d'erreurs (26), et l'impulsion de réinitialisation (RI) décrémente ou réinitialise le compteur d'erreurs (26), dans lequel le compteur d'erreurs (26) est incrémenté si l'écart (Delta _t) est situé à l'intérieur d'une fenêtre d'acceptation (AF) et à l'extérieur d'une fenêtre de valeurs optimales prédéfinie (WOpt), dans lequel le compteur d'erreurs (26) est décrémenté ou réinitialisé si l'écart (Delta _t) est situé à l'intérieur de la fenêtre d'acceptation (AF) et à l'intérieur de la fenêtre de valeurs optimales prédéfinie (WOpt), dans lequel un signal d'erreur (FS) est émis si un état de compteur d'erreurs (FZS) atteint ou dépasse une valeur limite prédéfinie (GW).

2. Procédé selon la revendication 1, **caractérisé en ce qu'**un niveau d'incrémentation et/ou un niveau de décrémentation du compteur d'erreurs (26) sont prédéfinis.

3. Dispositif (20) permettant de surveiller un signal de synchronisation de capteur (STS) dans une unité de capteur (10) qui est généré et émis avec une durée de période prédéfinie (T_STS) par un oscillateur de capteur (14) pour une transmission de données entre l'unité de capteur (10) et un appareil de commande (30), dans lequel un oscillateur de référence (32) génère et émet un signal de synchronisation de référence (RTS) avec une durée de période de référence prédéfinie (T_ref), dans lequel un moniteur d'oscillateur (22) reçoit le signal de synchronisation de capteur (STS) et le signal de synchronisation de référence (RTS) et les compare l'un avec l'autre, et établit sur la base de la comparaison un écart (Delta _t) de la durée de période actuelle (T_STS) par rapport à une durée de période théorique (T_STS_soll), et émet sur la base de l'écart établi (Delta_t) une impulsion de compteur (ZI) ou une impulsion de réinitialisation (RI), **caractérisé en ce que** l'impulsion de compteur (ZI) incrémente un compteur d'erreurs (26), et l'impulsion de réinitialisation (RI) décrémente ou réinitialise le compteur d'erreurs (26), dans lequel le moniteur d'oscillation (22) génère l'impulsion de compteur (ZI) si l'écart (Delta_t) est situé à l'intérieur d'une fenêtre d'acceptation (AF) et à l'extérieur d'une fenêtre de valeurs optimales prédéfinie (WOpt), dans lequel le moniteur d'oscillation (22) génère l'impulsion de réinitialisation (RI) si l'écart (Delta_t) est situé à l'intérieur de la fenêtre d'acceptation (AF) et à l'intérieur de la fenêtre de valeurs optimales prédéfinie (WOpt), et dans lequel le moniteur d'oscillateur (22) émet un signal d'erreurs (FS) si un niveau de compteur d'erreurs (FZS) du compteur d'erreurs (26) atteint ou dépasse une valeur limite prédéfinie (GW).

4. Dispositif (20) selon la revendication 3, **caractérisé par** un compteur (24) qui compte des impulsions du signal de synchronisation de capteur (STS), dans lequel le moniteur d'oscillateur (22) démarre le compteur (24) à un temps de départ (t_start, t_start'") auquel le moniteur d'oscillateur (22) reçoit une première impulsion de synchronisation (SP1) du signal de synchronisation de référence (RTS), et arrête le compteur (24) à un temps d'arrêt (t_stop, t_stop', t_stop") auquel le moniteur d'oscillateur (22) reçoit une deuxième impulsion de synchronisation (SP2, SP2', SP2", SP2‴).

5. Dispositif (20) selon la revendication 4, **caractérisé en ce que** le moniteur d'oscillateur (22) lit une position de compteur (ZS) du compteur (24) et la compare avec une position de compteur théorique (ZS_soll) qui est calculée selon le rapport entre la durée de période de référence (T_ref) et la durée de période théorique (T_STS_soll) du signal de synchronisation de capteur (STS).

6. Dispositif (20) selon l'une quelconque des revendications 3 à 5,
**caractérisé en ce que**
le moniteur d'oscillateur (22) calcule sur la base d'une plage de tolérance prédéfinie pour l'écart (Delta_t) la fenêtre d'acceptation (AF) qui est limitée vers le bas par une première position de compteur (ZS_min) et vers le haut par une deuxième position de compteur (ZS_max).

7. Dispositif (20) selon la revendication 6, **caractérisé en ce que** le moniteur d'oscillateur (22) calcule sur la base de la plage de tolérance prédéfinie pour l'écart (Delta_t) la fenêtre de valeurs optimales (AF) qui est limitée vers le bas par une troisième position de compteur (ZSW_min) qui est supérieure à la première position de compteur (ZS_min) et est limitée vers le haut par une quatrième position de compteur (ZSW_max) qui est inférieure à la deuxième position de compteur (ZS_max).

8. Dispositif (20) selon l'une quelconque des revendications 4 à 7, **caractérisé en ce que** le moniteur d'oscillateur (22) interprète la deuxième impulsion de synchronisation (SP2) comme une nouvelle première impulsion de synchronisation (SP1) et redémarre le compteur (24) si la position de compteur (ZS) actuellement lue est située à l'intérieur de la fenêtre d'acceptation (AF).

9. Dispositif (20) selon l'une quelconque des revendications 4 à 8, **caractérisé en ce que** le moniteur d'oscillateur (22) interprète la deuxième impulsion de synchronisation (SP2") comme une impulsion parasite si la position de compteur (ZS) actuellement lue correspondante est inférieure à la première position de compteur (ZS_min).

10. Dispositif (20) selon la revendication 9, **caractérisé en ce que** le moniteur d'oscillateur (22) ignore la deuxième impulsion de synchronisation (SP2'') interprétée comme une impulsion parasite et n'effectue aucune modification du compteur d'erreurs (26).

11. Dispositif (20) selon l'une quelconque des revendications 4 à 10, **caractérisé en ce que** le moniteur d'oscillateur (22) interprète la deuxième impulsion de synchronisation (SP2''') comme une nouvelle première impulsion de synchronisation (SP1) si la position de compteur actuelle lue (ZS) correspondante est supérieure à la deuxième position de compteur (ZS_max).

12. Dispositif (20) selon la revendication 11, **caractérisé en ce que** le moniteur d'oscillateur (22) redémarre le compteur (24) en réponse à la deuxième impulsion de synchronisation (SP2''') interprétée comme une nouvelle première impulsion de synchronisation (SP1) et n'effectue aucune modification du compteur d'erreurs (26) .

**Fig. 1**

**Fig. 2**

# Fig. 3

# Fig. 4

# Fig. 5

ZS_min    AF    ZS_max

ZSW_min    ZSW_max

WNeg    WOpt    WPos

SP1    SP2"

ZS, t

t_start    t_stop"

# Fig. 6

ZS_min    AF    ZS_max

ZSW_min    ZSW_max

WNeg    WOpt    WPos    SP2""

SP1

ZS, t

t_start    t_stop""
t_start""

# Fig. 7

# Fig. 8

**EP 3 692 679 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2009031060 A2
- DE 102012203664 A1